# EUROPÄISCHE PATENTSCHRIFT

(11) **EP 1 393 386 B1**
(45) Veröffentlichungstag und Bekanntmachung des Hinweises auf die Patenterteilung: **26.11.2008**
(21) Anmeldenummer: 02726081.9
(22) Anmeldetag: 18.04.2002
(51) Int. Cl.: H01L 41/04, H01L 41/083

(54) **PASSIVIERUNGSMATERIAL FÜR EIN ELEKTRISCHES BAUTEIL SOWIE PIEZOELEKTRISCHES BAUTEIL IN VIELSCHICHTBAUWEISE**
PASSIVATION MATERIAL FOR AN ELECTRIC COMPONENT AND PIEZOELECTRIC COMPONENT IN THE FORM OF A MULTILAYER STRUCTURE
MATERIAU DE PASSIVATION POUR COMPOSANT ELECTRIQUE ET COMPOSANT PIEZO-ELECTRIQUE A STRUCTURE MULTICOUCHE

(30) Priorität: 30.04.2001 DE 10121270
(43) Veröffentlichungstag der Anmeldung: 03.03.2004
(73) Patentinhaber: EPCOS AG, 81669 München (DE); SIEMENS AKTIENGESELLSCHAFT, 80333 München (DE)
(72) Erfinder: CRAMER, Dieter, 81827 München (DE); SCHUH, Carsten, 85598 Baldham (DE)
(74) Vertreter: Epping - Hermann - Fischer
(86) Internationale Anmeldenummer: PCT/DE2002/001444
(87) Internationale Veröffentlichungsnummer: WO 2002/089225

(56) Entgegenhaltungen:
- EP-A- 0 575 889
- DE-A- 2 544 140
- DE-A- 19 818 036
- GB-A- 1 383 498
- US-A- 5 218 259

## Beschreibung

Die vorliegende Erfindung betrifft zunächst ein Passivierungsmaterial für ein piezoelektrisches Bauteil gemäß dem Oberbegriff von Patentanspruch 1 sowie ein piezoelektrisches Bauteil in Vielschichtbauweise.

Piezoelektrische Bauteile können beispielsweise in Form von Piezoaktoren als Vielschichtbauelemente mit einer Anzahl von jeweils alternierend angeordneten piezoelektrischen Keramikschichten und Elektrodenschichten ausgebildet sein und gewinnen in der modernen Elektrotechnik immer mehr an Bedeutung. Beispielsweise werden Piezoaktoren als Stellantriebe, in Verbindung mit Ventilen und dergleichen, eingesetzt.

Ein bekannter Piezoaktor ist beispielsweise in der DE 196 46 676 C1 ausführlich beschrieben. Bei derartigen Piezokeramiken wird der Effekt ausgenutzt, daß diese sich unter einem mechanischen Druck, beziehungsweise Zug, aufladen und andererseits bei Anlegen einer elektrischen Spannung entlang der Hauptachse der Keramikschicht ausdehnen. Zur Vervielfachung der nutzbaren Längenausdehnung werden beispielsweise monolithische Vielschichtaktoren verwendet, die aus einem gesinterten Stapel dünner Folien aus Piezokeramik (beispielsweise Bleizirkonattitanat) mit eingelagerten metallischen Elektrodenschichten bestehen. Die Elektrodenschichten sind wechselseitig aus dem Stapel herausgeführt und über Außenmetallisierungen elektrisch parallel geschaltet. Auf den beiden Kontaktseiten des Stapels ist hierzu jeweils eine streifen- oder bandförmige, durchgehende Außenmetallisierung aufgebracht, die mit allen Elektrodenschichten gleicher Polarität verbunden ist.

Zwischen der Außenmetallisierung und den elektrischen Anschlüssen des Piezoaktors wird häufig noch eine in vielen Formen ausführbare Weiterkontaktierung, beispielsweise ein Cu-kaschierter Kaptonfolienstreifen oder dergleichen, aufgebracht. Legt man eine elektrische Spannung an die Außenkontaktierung, so dehnen sich die Piezofolien in Feldrichtung aus. Durch die mechanische Serienschaltung der einzelnen Piezofolien wird die Nenndehnung des gesamten Stapels schon bei relativ niedrigen elektrischen Spannungen erreicht.

Zur Erzielung einer optimalen Auslenkung des piezokeramischen Vielschichtaktors bei gleichzeitig minimalem Platzbedarf müssen die Elektrodenschichten den gesamten Querschnitt des Aktors, bis beispielsweise auf eine inaktive Kontaktierungszone, umfassen. Das bedeutet, daß Elektrodenschichten alternierender Polarität an den seitlichen Oberflächen der Vielschichtkeramik freiliegen.

Aus diesem Grund ist es erforderlich, diese freiliegenden Elektrodenschichten mit einer geeigneten Passivierung zu versehen. Bei einer Passivierung handelt es sich im allgemeinen um eine Art Schutzschicht, Isolationsschicht oder dergleichen, mittels derer elektrische Überschläge und Kurzschlüsse zwischen benachbarten Elektrodenschichten vermieden werden können. Ohne eine Passivierung könnten solche Überschläge und Kurzschlüsse, beispielsweise durch mechanische Beschädigung der Oberfläche oder durch Kontaminierung mit Verunreinigungen (beispielsweise Schleifstaub, Fingerabdrücke und dergleichen), Feuchtigkeit (beispielsweise Ag-Migration oder dergleichen) oder Betriebsstoffen (beispielsweise Diesel, Rapsmethylester und dergleichen), hervorgerufen werden. Derartige Beschädigungen und/oder Kontaminierungen können insbesondere im Betrieb des Aktors, aber auch während des Herstellungsprozesses hervorgerufen werden.

Passivierungen werden derzeit in einer Weise hergestellt, daß die Vielschichtkeramik nach der Außenmetallisierung per Hand mit einem Passivierungsmaterial in Form einer selbsthaftenden Silikonmasse bestrichen wird. Dieses Silikonelastomer wird anschließend in einem Trockenschrank etwa 30 Minuten bei 150 °C ausgehärtet. Anschließend werden die so passivierten Aktoren unter Verwendung des gleichen Silikonelastomers mit einem zylindrischen Kunststoffmantel umgeben. Der Auswahl des Passivierungsmaterials liegen dabei folgende Kriterien zu Grunde:

Zunächst muß das Passivierungsmaterial eine Dauertemperaturbeständigkeit von > 150 °C aufweisen. Der Grund hierfür liegt in der Tatsache, daß piezokeramische Vielschichtaktoren der genannten Art beispielsweise als Aktoren in einem Dieselantriebsaggregat eingesetzt werden, das eine derart hohe Betriebstemperatur aufweist. Weiterhin sollte das Passivierungsmaterial möglichst selbsthaftend auf der Vielschichtkeramik sein. Schließlich ist es für Passivierungsmaterialien bisher Voraussetzung, daß diese eine Reißdehnung von > 200 % aufweisen, um an Polungsrissen im Aktorbetrieb auftretende Dehnungen verkraften zu können.

Passivierungsmaterialien auf der Basis selbsthaftender Silikonmassen weisen jedoch, insbesondere im Betrieb der Piezoaktoren in Dieselinjektoren, einen gravierenden Nachteil auf. So sind die bisher verwendeten Passivierungsmaterialien auf Silikon-Basis nur mangelhaft beständig gegen Quellen bei Benetzung mit Dieselkraftstoff oder Rapsmethylester (RME). Weiterhin kann sich die Passivierung während des Betriebs des piezoelektrischen Bauteils von dessen Oberfläche(n) ablösen.

Aus DE 198818036 A1 ist eine Piezoaktoranordnung bekannt, bei der eine aus einem Festsilikon oder flouriertem SilikonElastomer bestehende Kunststoffmasse einen Piezoaktor umhüllt.

Aus US 5,218,259 ist ein Piezoaktor bekannt, der von einem Silikonhaftmittel mit geringer Viskosität umhüllt ist.

Aus DE 2544140 ist es bekannt, Polyurethan als Feststoffisolation direkt auf piezoelektrisches Material aufzutragen.

Aus GB 1383498 ist ein elektrische Isolationsbeschichtung bekannt, beispielsweise eine polyimidehaltige Schicht, welche auf metallische Substrate oder harzartige Substrate aufgetragen werden kann.

Ausgehend vom genannten Stand der Technik liegt der vorliegenden Erfindung die Aufgabe zu Grunde, ein Passivierungsmaterial bzw. ein piezoelektrisches Bauteil in Vielschichtbauweise mit dem Passivierungsmaterial anzugeben, bei dem die geschilderten Nachteile vermieden werden können. Insbesondere soll ein Passivierungsmaterial bzw. ein piezoelektrisches Bauteil mit dem Passivierungsmaterial bereitgestellt werden, das eine hohe Zuverlässigkeit und Lebensdauer, vorzugsweise auch beim Einsatz in Dieselapplikationen ermöglicht beziehungsweise aufweist.

Diese Aufgabe wird gelöst durch das piezoelektrische Bauteil gemäß Patentanspruch 1. Weitere Vorteile, Merkmale, Details, Aspekte und Effekte der Erfindung ergeben sich aus den Unteransprüchen, der Beschreibung sowie der Zeichnung. Merkmale und Details, die im Zusammenhang mit dem erfindungsgemäßen Passivierungsmaterial beschrieben sind, gelten selbstverständlich auch für das erfindungsgemäße piezoelektrische Bauteil und umgekehrt.

Gemäß dem ersten Aspekt der Erfindung wird ein Passivierungsmaterial für ein piezoelektrisches Bauteil in Vielschichtbauweise, bereitgestellt, das erfindungsgemäß dadurch gekennzeichnet ist, daß das Passivierungsmaterial eine Reißfestigkeit aufweist, die kleiner ist als die Haftfestigkeit des Passivierungsmaterials auf dem elektrischen Bauteil.

Durch die Verwendung eines erfindungsgemäßen Passivierungsmaterials auf einem piezoelektrischen Bauteil werden Bauteile mit hoher Zuverlässigkeit und Lebensdauer geschaffen. Dabei ist die Erfindung nicht auf bestimmte Typen von piezoelektrischen Bauteilen beschränkt. Vielmehr kann das Passivierungsmaterial auf jeder Form piezoelektrischer Bauteile eingesetzt werden, die eine entsprechende Passivierung benötigen. Vorteilhafterweise kann das erfindungsgemäße Passivierungsmaterial jedoch für ein piezoelektrisches Bauteil in Vielschichtbauweise eingesetzt werden, beispielsweise einen in der Beschreibungseinleitung erwähnten piezokeramischen Aktor in Vielschichtbauweise.

Waren für die bisher aus dem Stand der Technik bekannten Passivierungsmaterialien hoch dehnbare Stoffe Voraussetzung, wurde nun überraschenderweise herausgefunden, daß als geeignete Passivierungsmaterialien vorteilhaft derartige Materialien verwendet werden können, deren Reißfestigkeit kleiner ist als die Haftfestigkeit des Materials auf dem elektrischen Bauteil.

Als Reißfestigkeit wird dabei die (Zug-)Spannung im Augenblick des Reißens verstanden. Als Haftfestigkeit wird diejenige Spannung verstanden, bei der die Haftung des Passivierungsmaterials auf dem elektrischen Bauteil unterbrochen wird. Bei der Haftfestigkeit handelt es sich somit beispielsweise um diejenige Spannung, bei der sich das Passivierungsmaterial vom elektrischen Bauteil ablöst.

Die vorliegende Erfindung geht unter anderem von dem Grundgedanken aus, daß polungs- und betriebsbedingte mechanische Schädigungen des elektrischen Bauteils, insbesondere eines piezoelektrischen Bauteils in Vielschichtbauweise, vor allem in den piezoelektrisch inaktiven Kontaktierungszonen beginnen. Dort kommt es an den bis zur Oberfläche des Bauelements führenden Elektroden zu Delaminationsrissen im Interface Innenelektrode - und dem die Elektrode tragenden Material, beispielsweise einer Keramikschicht. Eine Verbindung zwischen zwei Elektrodenschichten unterschiedlicher Polarität findet bei Rißfortschritt im Normalfall nicht statt. Dementsprechend kann es auch bei Anwesenheit von Feuchtigkeit und dergleichen im Rißspalt nicht zu einer Entstehung von Überschlägen oder Kurzschlüssen zwischen Elektrodenschichten entgegengesetzter Polarität im Inneren des elektrischen Bauteils kommen.

Entscheidend für die Zuverlässigkeit elektrischer Bauteile, insbesondere von piezoelektrischen Bauteilen in Vielschichtbauweise, ist hingegen, daß die Haftung des Passivierungsmaterials auf der Oberfläche des elektrischen Bauteils in der Umgebung der Rißöffnung ungestört erhalten bleibt. Reißt die Passivierungsschicht im Bereich eines Delaminationsrisses, etwa der Keramikschicht, dabei nicht ein, so werden bei jeder Auslenkung des piezoelektrischen Bauteils, und damit der Öffnung der Rißflanken, erhebliche Zug- und Scherspannungen in das Interface elektrisches Bauteil - Passivierungsmaterial in der Umgebung des Risses eingebracht. Dies kann zu einer sukzessiven Ablösung des Passivierungsmaterials in diesem Bereich führen. Dringt nun Feuchtigkeit oder dergleichen in den zwischen der Oberfläche des elektrischen Bauteils und dem Passivierungsmaterial gebildeten Spalt ein, so ist ein schneller Ausfall des elektrischen Bauteils durch elektrischen Kurzschluß entlang der Oberfläche des elektrischen Bauteils zwischen zwei benachbarten Elektrodenschichten entgegengesetzter Polarität zu erwarten.

Durch die Verwendung des erfindungsgemäßen Passivierungsmaterials werden diese Nachteile nunmehr vermieden. Bevor es nämlich zu einem Ablösen des Passivierungsmaterials von der Oberfläche des piezoelektrischen Bauteils auf Grund der zuvor beschriebenen Umstände kommen kann, entsteht in dem Passivierungsmaterial ein Riß. Durch einen solchen Riß, insbesondere senkrecht zur Oberfläche des Passivierungsmaterials, werden die Zug- und Scherspannungen in der Ebene des Passivierungsmaterials, beispielsweise einer Passivierungsschicht, die durch die Arbeitsdehnung des ummantelten elektrischen Bauteils verursacht werden, derart reduziert, daß sich das Passivierungsmaterial nicht mehr von der Oberfläche des elektrischen Bauteils ablöst. Reißfestigkeit und Haftfestigkeit sind dabei vorteilhaft bezüglich der Ebenen mechanischer Spannungen in der Ebene des Passivierungsmaterials, beispielsweise einer Passivierungsschicht, gemeint.

Durch die erfindungsgemäße Ausgestaltung des Passivierungsmaterials steht nunmehr eine sehr viel größere Auswahl an potentiellen Passivierungsmaterialien zur Verfügung, da nunmehr insbesondere auch höher vernetzte Systeme mit geringerer Dehnbarkeit miteinbezogen werden können.

Vorteilhaft kann das Passivierungsmaterial aus wenigstens einem Kunststoff gebildet sein.

Dabei kann als geeigneter Kunststoff grundsätzlich jede Form von Polymeren verwendet werden, die die erfindungsgemäßen Materialeigenschaften aufweisen. So können nunmehr insbesondere auch solche Polymere eingesetzt werden, die über alternative Beschichtungsverfahren erzeugt werden können, wie beispielsweise Plasma-Abscheidung, Korona-Abscheidung, Sputtern, Flammen-CVD und dergleichen.

Bei dem Kunststoff kann es sich beispielsweise um einen thermoplastischen Kunststoff handeln, der sich dadurch auszeichnet, daß er unter gewissen Bedingungen einen thermoplastischen Zustand einnehmen kann.

Beispielsweise kann der wenigstens eine Kunststoff in Form eines höher vernetzten Kunststoffs vorliegen.

Vorzugsweise kann das Passivierungsmaterial aus wenigstens einem Material gebildet sein, das während der Verarbeitung niederviskose Eigenschaften aufweist. Als niederviskose Materialien werden dabei grundsätzlich solche Materialien verstanden, die während ihrer Verarbeitung eine geringe Viskosität aufweisen, wobei als Viskosität generell eine Vergleichsgröße für die Zähigkeit oder innere Reibung des Materials, insbesondere in flüssiger oder semi-flüssiger Form, verstanden wird.

Die Verwendung eines derartigen Materials ist insbesondere deshalb von Vorteil, da die Ummantelung beziehungsweise die Beschichtung des elektrischen Bauteils mit einem geeigneten Passivierungsmaterial äußerst komplex ist und deshalb einen sehr schonenden Herstellungsprozeß erfordert. Das Aufbringen des Passivierungsmaterials auf das piezoelektrische Bauteil kann beispielsweise mittels eines Spritzgußverfahrens oder dergleichen erfolgen.

Vorteilhaft kann das Passivierungsmaterial aus wenigstens einem Polyurethan gebildet sein. Bei dem Polyurethan handelt es sich vorzugsweise um ein gießfähiges Polyurethan. Als geeignete Polyurethane können vorteilhaft höher vernetzte Formulierungen verwendet werden.

Insbesondere gießfähige Polyurethane haben den Vorteil, daß sie sich durch eine sehr geringe Viskosität während der Verarbeitung auszeichnen.

Polyurethane haben weiterhin den Vorteil, daß sie auch bei tiefen Temperaturen Dehnungen bis zu 200 Prozent zulassen. Dies ist insbesondere dann von Vorteil, wenn das Polyurethan als Passivierungsmaterial für ein piezoelektrisches Bauteil in Vielschichtbauweise verwendet wird, beispielsweise einen Aktor. Im Einsatzfall vollzieht ein solcher Piezoaktor beträchtliche Längenänderungen. Diese dynamischen Bewegungen sollten vom Passivierungsmaterial ebenfalls bestmöglich ausgeführt werden. Während bei Raumtemperatur oder auch erhöhter Temperatur diese Anforderungen selten als kritisch zu bewerten sind, gilt dies nicht mehr bei tiefen Temperaturen von beispielsweise weniger als -20 °C, insbesondere weniger als -40 °C. Polyurethane haben den Vorteil, daß sie auch bei Temperaturen von -40 °C noch Reißdehnungen aufweisen, die oberhalb von 200 Prozent liegen.

Polyurethane haben auch eine sehr gute Medienbeständigkeit in Wasser und Dieselöl. Dies wird im Zusammenhang mit dem weiter unten beschriebenen Quellgrad noch ausführlicher erläutert. Weiterhin weisen Polyurethane nur eine geringe Permeation von Medien, eine hohe dynamische Beständigkeit sowie eine gute Haftungsfähigkeit zu einer Oberfläche des piezoelektrischen Bauteils, beispielsweise zu einer Keramikoberfläche auf. Schließlich haben Polyurethane im Vergleich zu anderen Materialien einen relativ geringen Preis.

Polyurethane weisen schließlich noch gute Hitzealterungswerte bei 150 °C auf. Die Hitzealterung führt in der Regel zu einer Erweichung des Materials, was sich in einer kontinuierlichen Abnahme der Härte, beispielsweise der Shore-A-Härte widerspiegelt. Verbunden mit der abnehmenden Härte der Proben ist eine Zunahme der Reißdehnung, wobei sich die positive Entwicklung der Reißdehnung zu hohen Werten mit zunehmender Lagerzeit des Materials wieder verringert. Die Zugfestigkeit zeigt mit zunehmender Lagerzeit eine ähnliche Entwicklung wie die Reißdehnung. Nach einer anfänglichen Zunahme der Festigkeit folgt ein rascher Abfall, der sich aber bei sehr langen Lagerzeiträumen auf einem nahezu konstanten Niveau einpendelt.

In weiterer Ausgestaltung kann das Passivierungsmaterial aus wenigstens einem Material auf Fluor-Basis ausgebildet sein.

Dabei kann das Material vorzugsweise ein Fluor-Kunststoff sein. Hierbei handelt es sich beispielsweise um PTFE (Teflon), PFA, FEP, ETFE und dergleichen. Als geeignetes Passivierungsmaterial kann aber auch ein Fluor-Silikon oder ein Fluor-Kautschuk eingesetzt werden. Fluor-Kautschuke weisen insbesondere eine gute Medienbeständigkeit sowie auch eine gute Temperaturbeständigkeit sowie eine geringe Viskosität während der Verarbeitung auf. Insbesondere weisen Fluor-Kautschuke eine gute Temperaturstabilität auch bei niedrigsten Temperaturen, etwa bei Temperaturen von -40°C auf.

Vorteilhaft kann das Passivierungsmaterial aus wenigstens einem Material auf Fluor-Silikon-Kautschuk-Basis gebildet sein. Hierbei handelt es sich um ein Material, das auch als Flüssigsystem, das heißt als Material mit niederviskosen Eigenschaften während der Verarbeitung, erhältlich ist. Fluor-Silikon-Kautschuke weisen weiterhin eine sehr gute Temperaturstabilität auch bei niedrigen Temperaturen von bis zu -40 °C sowie Reißdehnungen auf, die oberhalb von 200 Prozent liegen können.

Fluor-Silikon-Kautschuk zeigt eine gute Medienbeständigkeit, insbesondere in den Medien Wasser, Dieselöl, Rapsmethylester, was sich durch geringe Quellwerte auch bei hohen Betriebstemperaturen zeigt. Die Bedeutung des Quellgrads wird im weiteren Verlauf der Beschreibung noch näher erläutert.

In weiterer Ausgestaltung kann das Passivierungsmaterial beispielsweise aus wenigstens einem Harz gebildet sein. Hier sind beispielsweise Silikonharze, Epoxidharze und dergleichen denkbar.

Vorzugsweise kann das Passivierungsmaterial auch aus wenigstens einem Material aus der Gruppe der Latices gebildet sein. Als geeignetes Material ist hier beispielsweise, jedoch nicht ausschließlich Acrylat-Latex zu nennen. Ein solcher Acrylat-Latex kann vorteilhaft in Wasser dispergiert sein.

In weiterer Ausgestaltung kann das Passivierungsmaterial aus wenigstens einem Material aus der Gruppe der Polyimide und/oder der Polyamide und/oder der Polymethylacrylate und/oder der Parylene gebildet sein. Bei dem Polyimid kann es sich beispielsweise um Kapton handeln. Parylen kann beispielsweise mittels Gasphasenabscheidung gewonnen werden.

Das Passivierungsmaterial kann vorteilhaft jeweils aus einem einzelnen der vorstehend beschriebenen Materialien oder aber aus mehreren Materialien, die in beliebiger Kombination vorliegen können, gebildet sein. Wichtig ist lediglich, daß das Passivierungsmaterial eine Reißfestigkeit aufweist, die kleiner ist als dessen Haftfestigkeit auf dem elektrischen Bauteil.

Vorteilhaft kann das Passivierungsmaterial einen Quellgrad in flüssigen Medien von ≤ 40 Prozent aufweisen. Bei dem Quellgrad handelt es sich dabei um eine Volumenänderung in Prozent gemessen über einen bestimmten Zeitraum.

Wenn das piezoelektrische Bauteil, das mit einem Passivierungsmaterial versehen ist, beispielsweise als Piezoaktor ausgebildet ist, der als Antriebsaggregat in einer Dieselmaschine vorgesehen ist, muß das den Aktor ummantelnde Material, beispielsweise das die Oberfläche des Aktors bedeckende Passivierungsmaterial, gegenüber den umgebenden Medien, wie beispielsweise Wasser, Diesel, Rapsmethylester oder dergleichen, beständig sein. Dies gilt insbesondere für Betriebstemperaturen bis zu 150 °C, die als thermische Spitzenbelastungen im Dieselmotor auftreten können. Da das Passivierungsmaterial unter anderem als Schutz für den Piezoaktor dient, muß es ein gewisses Maß an Dichtigkeit gegenüber diesen Medien aufweisen. Als Maß für die Barriereeigenschaften wird dabei die Quellung beziehungsweise der Quellgrad der Materialien in den entsprechenden Medien unter der Annahme herangezogen, daß ein geringer Quellgrad gleichbedeutend mit einer erhöhten Dichtigkeit ist.

Die Bestimmung des Quellgrads erfolgt beispielsweise dadurch, daß eine Probe aus dem Passivierungsmaterial über einen bestimmten Zeitraum bei einer bestimmten Temperatur in ein Medium eingelegt wird, wobei die Quellung nach Ablauf der Versuchsdauer gemessen wird, indem das Volumen der Probe vor Beginn und nach dem Ende des Quellversuchs gemessen wird.

In einer durchgeführten Versuchsreihe wurden verschiedene Passivierungsmaterialien beispielsweise für eine Zeitdauer von 96 Stunden in Wasser, Dieselöl und Rapsmethylester eingelegt. Dabei sollten solche Passivierungsmaterialien gefunden werden, die einen Quellgrad von ≤ 40 Prozent, vorzugsweise ≤ 20 Prozent, ganz besonders bevorzugt von ≤ 10 Prozent aufwiesen.

Bei Quellversuchen in Wasser bei 100 °C ergab sich, daß als Passivierungsmaterialien insbesondere Polyurethan und Fluor-Silikon-Kautschuke geeignet sind, deren Quellgrad bei unter 5 vol.-% lag.

Die Untersuchung der Quellung von Passivierungsmaterialien in Dieselöl wurden bei Temperaturen von 140 °C durchgeführt. Auch hier ergaben sich als vorteilhafte Materialien Fluor-silikon-Kautschuke und Polyurethan.

Die Quellversuche in Rapsmethylester wurden ebenfalls bei 140 °C durchgeführt. Auch hier ergaben sich als besonders geeignete Passivierungsmaterialien Fluor-Silikon-Kautschuke und Polyurethan. Beide Materialien wiesen auch nach einer Einlagerungszeit von 96 Stunden nur einen mäßig ausgeprägten Quellgrad von kleiner/gleich 40 Prozent auf.

Vorteilhaft weist das Passivierungsmaterial eine Dauertemperaturbeständigkeit von > 150 °C auf.

Das wie vorstehend beschriebene erfindungsgemäße Passivierungsmaterial weist gegenüber den aus dem Stand der Technik bekannten, bisher eingesetzten Passivierungsmaterialien, bei denen die Forderung nach einer hohen Dehnbarkeit erfüllt werden mußte, eine ganze Reihe von Vorteilen auf. So sind die erfindungsgemäßen Passivierungsmaterialien beispielsweise erheblich beständiger gegenüber einem Quellen, insbesondere in Diesel und Rapsmethylester. Weiterhin können die erfindungsgemäßen Passivierungsmaterialien hohe Haftfestigkeiten auf dem elektrischen Bauteil aufweisen, was mit oder ohne den Einsatz von Verbindungsmitteln wie Haftvermittlern und dergleichen erfolgen kann. Weiterhin weisen die Passivierungsmaterialien während der Verarbeitung vorzugsweise niederviskose Eigenschaften auf, was insbesondere deren Herstellung und Aufbringung auf dem elektrischen Bauteil, beispielsweise mittels eines Gießverfahrens oder dergleichen, erleichtert. Weiterhin zeigen die erfindungsgemäßen Passivierungsmaterialien prozeßtechnisch optimierbare Vernetzungs- und/oder Härtungsverläufe. Die erfindungsgemäßen Passivierungsmaterialien können nunmehr auch mittels alternativer Beschichtungsverfahren auf das elektrische Bauteil aufgebracht werden, beispielsweise mittels Tauchen, Spritzen, CVD (Chemical Vapour Deposition) und dergleichen. Darüber hinaus zeigen die Passivierungsmaterialien eine deutlich geringere Permeabilität für Wasserdampf und andere Gase sowie eine erheblich höhere elektrische Isolation und Durchschlagsfestigkeit. Der Einsatz der erfindungsgemäßen Passivierungsmaterialien auf dem elektrischen Bauteil führt schließlich auch zu einer deutlichen Verbesserung von dessen Funktionalität sowie zu einer Vereinfachung der verfahrenstechnischen Umsetzung.

Gemäß einem zweiten Aspekt wird ein piezoelektrisches Bauteil in Vielschichtbauweise bereitgestellt, bei dem alternierend immer eine piezoelektrische Keramikschicht und eine Elektrodenschicht zur Bildung eines Stapels übereinander angeordnet ist, wobei sich jede Elektrodenschicht zumindest bereichsweise bis zu wenigstens einer seitlichen Oberfläche des Stapels erstreckt, und bei dem auf dieser wenigstens einen seitlichen Oberfläche eine Passivierung vorgesehen ist. Das piezoelektrische Bauteil ist erfindungsgemäß dadurch gekennzeichnet, daß die Passivierung aus einem wie vorstehend beschriebenen erfindungsgemäßen Passivierungsmaterial gebildet ist.

Durch die Ausgestaltung der Passivierung auf der Basis eines erfindungsgemäßen Passivierungsmaterials wird es nunmehr möglich, zuverlässige piezoelektrische Bauteile mit hoher Lebensdauer bereitzustellen, bei denen die Haftung der Passivierung auf der Oberfläche des Stapels zu jeder Zeit, insbesondere auch nach Bildung von Rissen in der oder den Keramikschichten ungestört erhalten bleibt. Der Grund hierfür liegt beispielsweise in der im Vergleich zur Haftfestigkeit geringeren Reißfestigkeit des Passivierungsmaterials. Zu den Vorteilen, Wirkungen, Effekten sowie der Funktionsweise des piezoelektrischen Bauteils wird zur Vermeidung von Wiederholungen auf die vorstehenden Ausführungen zum erfindungsgemäßen Passivierungsmaterial vollinhaltlich Bezug genommen und hiermit verwiesen.

Vorzugsweise kann das Passivierungsmaterial mittels wenigstens eines Verbindungsmittels an der wenigstens einen seitlichen Oberfläche des Stapels angeordnet sein. Dabei ist ein solches Verbindungsmittel jedoch nicht in jedem Fall erforderlich. Wenn das Passivierungsmaterial beispielsweise aus wenigstens einem Polyurethan gebildet ist, ist die Verbindung zwischen dem Polyurethan nach dessen Aufbringung auf die Keramikschichten derart stark ausgebildet, daß keine zusätzlichen Verbindungsmittel erforderlich sind. Wenn eine solche starke Verbindung jedoch nicht realisierbar ist, kann die entsprechende Haftfestigkeit über Verwendung geeigneter Verbindungsmittel realisiert werden.

Dabei ist die Erfindung nicht auf bestimmte Typen von Verbindungsmitteln beschränkt. Beispielsweise, jedoch nicht ausschließlich, können als Verbindungsmittel etwa geeignete Haftvermittler eingesetzt werden. Die Auswahl eines geeigneten Haftvermittlers ergibt sich in diesem Fall je nach der Art des verwendeten Passivierungsmaterials sowie des Materials des piezoelektrischen Bauteils, auf das das Passivierungsmaterial aufgebracht werden soll.

Vorteilhaft kann das piezoelektrische Bauteil in Vielschichtbauweise als piezoelektrischer Aktor oder als piezoelektrischer Wandler ausgebildet sein. Vorteilhafte Ausführungsformen für Aktoren sind beispielsweise Stapelaktoren, Transversalaktoren, Biegeaktoren oder dergleichen.

Besonders vorteilhaft kann das piezoelektrische Bauteil als piezoelektrischer Aktor in einem Dieselantriebsaggregat ausgebildet sein. Durch Einsatz des erfindungsgemäßen Passivierungsmaterials auf der Oberfläche beziehungsweise den Oberflächen des piezoelektrischen Bauteils kann nämlich unter anderem eine dieselresistente und zuverlässige Passivierung des piezoelektrischen Aktors realisiert werden.

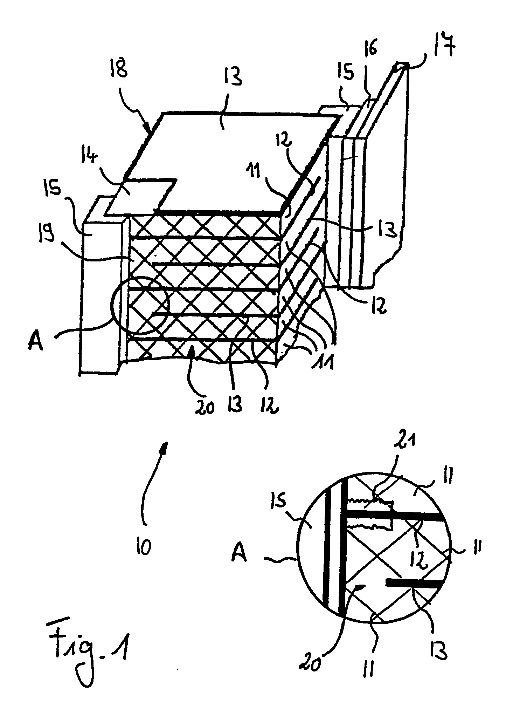

Die Erfindung wird nun an Hand eines Ausführungsbeispiels unter Bezugnahme auf die beiliegende Zeichnung näher erläutert. Dabei zeigt die einzige Figur 1 in perspektivischer Ansicht einen Teilausschnitt aus einem erfindungsgemäßen piezoelektrischen Bauteil in Vielschichtbauweise.

In Figur 1 ist ein als Piezoaktor ausgebildetes piezoelektrisches Bauteil 10 in Vielschichtbauweise dargestellt. Der Piezoaktor 10 bildet einen aus zahlreichen piezoelektrischen Keramikschichten 11 und Elektrodenschichten 12, 13 aufgebauten Stapel 18. Die Elektrodenschichten 12 und 13 haben dabei jeweils unterschiedliche Polarität, wobei Elektrodenschichten gleicher Polarität jeweils als erste Elektrodenschichten 12 beziehungsweise zweite Elektrodenschichten 13 bezeichnet sind. Elektrodenschichten 12 beziehungsweise 13 gleicher Polarität sind jeweils mit einer Außenmetallisierung 15 verbunden.

Erkennbar sind weiterhin inaktive Isolationszonen 14, die abwechselnd in gegenüber liegenden Ecken der aufeinanderfolgenden, sich in diesem Fall nicht über den gesamten Stapelquerschnitt erstreckenden Elektrodenschichten 12, 13 angeordnet sind. Dieser Aufbau ermöglicht den gemeinsamen Anschluß aller ersten Elektrodenschichten 12, beziehungsweise aller zweiten Elektrodenschichten 13, mit jeweils gleicher Polarität durch eine gemeinsame, vertikale Außenmetallisierung 15. Bei der Außenmetallisierung 15 kann es sich beispielsweise um ein entsprechendes Metallisierungsband handeln, das gegebenenfalls über eine entsprechende Weiterkontaktierung 16 mit weiteren, seitlich überstehenden Kontaktfahnen 17 weiterkontaktiert ist.

Während des Betriebs des Piezoaktors 10 ist dieser enormen Spannungen ausgesetzt. Diese Spannungen führen dazu, daß in den Keramikschichten 11 Risse auftreten können. Derartige polungs- und betriebsbedingte mechanische Schädigungen des Piezoaktors 10 beginnen vor allem im Bereich der inaktiven Isolationszonen 14. Dort kommt es an den bis zur seitlichen Oberfläche 19 des Stapels führenden Elektrodenschichten 12, 13 zu Delaminationsrissen im Interface Elektrodenschicht - Keramik. Eine Verbindung zwischen zwei Elektrodenschichten 12, 13 unterschiedlicher Polarität findet bei Rißfortschritt im Normalfall nicht statt. Dementsprechend kann es auch bei Anwesenheit von Feuchtigkeit und dergleichen im Rißspalt nicht zur Entstehung von Überschlägen oder Kurzschlüssen zwischen den Elektrodenschichten 12, 13 entgegengesetzter Polarität im Inneren des Piezoaktors 10 kommen.

Um mit dem Piezoaktor 10 eine optimale Auslenkung bei gleichzeitig minimalem Platzbedarf erzielen zu können, müssen die Elektrodenschichten 12, 13 den gesamten Querschnitt des Piezoaktors 10, bis auf die inaktive Isolationszone 14, umfassen. Das bedeutet, daß die Elektrodenschichten 12, 13 alternierender Polarität an den seitlichen Oberflächen 19 des Stapels 18 des Piezoaktors 10 freiliegen. Aus diesem Grund ist es erforderlich, daß die seitlichen Oberflächen 19 des Stapels 18, an denen Elektrodenschichten 12, 13 freiliegen, mit einer geeigneten Passivierung 20 versehen werden. In Figur 1 ist an einer seitlichen Oberfläche 19 eine solche Passivierung 20 in Form einer Kreuzschraffur dargestellt. Der besseren Übersicht halber ist nur eine der Oberflächen 19 mit einer Passivierung 20 versehen. Selbstverständlich können auch alle Oberflächen 19 des Stapels 18 mit einer Passivierung 20 versehen sein. Darüber hinaus ist es auch denkbar, das gesamte piezoelektrische Bauteil 10, einschließlich der Außenmetallisierungen 15, Weiterkontaktierungen 16, Kontaktfahnen 17 und dergleichen mit einer Umhüllung aus Passivierungsmaterial zu versehen. Dazu kann das gesamte Bauteil beispielsweise in einer entsprechenden Umhüllung aus Passivierungsmaterial vergossen sein.

Bei der Passivierung 20 handelt es sich um eine Art Schutzschicht, die elektrische Überschläge und Kurzschlüsse zwischen benachbarten Elektrodenschichten 12, 13 unterschiedlicher Polarität vermeidet. Solche Kurzschlüsse und Überschläge können beispielsweise durch mechanische Beschädigung der Oberfläche 19 des Stapels 18, oder aber durch Kontaminierung mit Verunreinigungen, Feuchtigkeit, Betriebsstoffen und dergleichen erfolgen.

Entscheidend für die Zuverlässigkeit des Piezoaktors 10 ist dabei, daß die Haftung der Passivierung 20, beispielsweise einer geeigneten Passivierungsschicht, die mittels eines Siebdruckverfahrens, Gießverfahrens oder dergleichen auf die Oberfläche 19 des Stapels aufgebracht werden kann, auf der Oberfläche der Keramikschichten 11 zu jeder Zeit ungestört erhalten bleibt. Hierbei muß die Passivierung 20 insbesondere in solchen Bereichen ungestört erhalten bleiben, in denen die weiter oben bereits erwähnten Delaminationsrisse im Keramikmaterial auftreten. Reißt die Passivierung 20 im Bereich eines solchen Delaminationsrisses der Keramik dabei nicht ein, so werden bei jeder Auslenkung des Piezoaktors 10 und damit bei jeder Öffnung der Rißflanken, erhebliche Zug-und Scherspannungen in das Interface Keramik - Passivierung in der Umgebung des Risses eingebracht. Dies führt zu einer sukzessiven Ablösung der Passivierung 20 in diesem Bereich.

Dringt nun Feuchtigkeit und dergleichen in den zwischen der Oberfläche 19 des Aktors und die Passivierung 20 gebildeten Spalt ein, so ist ein schneller Ausfall des Piezoaktors 10 durch elektrischen Kurzschluß entlang der Oberfläche 19 zwischen zwei benachbarten Elektrodenschichten 12, 13 unterschiedlicher Polarität zu erwarten.

Um diese Nachteile zu vermeiden, ist das Passivierungsmaterial der Passivierung 20 nunmehr in einer Weise ausgebildet, daß dieses eine Reißfestigkeit aufweist, die kleiner ist als die Haftfestigkeit des Passivierungsmaterials auf dem Piezoaktor 10. Das bedeutet, daß es zu der vorstehend beschriebenen, nachteiligen Ablösung der Passivierung 20 von der Oberfläche 19 des Stapels 18 nicht mehr kommen kann, da die Passivierung 20 vor der Ablösung einreißt. Dies soll anhand des mit einem Kreis markierten vergrößerten Ausschnitts A in Figur 1 verdeutlicht werden. Im vergrößerten Ausschnitt A ist dazu exemplarisch ein Riß 21 in der Passivierung 20 dargestellt, der sich beispielsweise senkrecht zur Oberfläche der Passivierung 20 erstreckt. Durch einen solchen Riß 21 werden die Zug- und Scherspannungen in der Ebene der Passivierung 20, die durch die Arbeitsdehnung des mit der Passivierung 22 ummantelten Piezoaktors 10 verursacht werden, derart reduziert, daß sich die Passivierung 20 nicht mehr von der Oberfläche 19 des Stapels 18 ablöst.

Vorteilhaft wird als geeignetes Passivierungsmaterial wenigstens ein Polyurethan und/oder wenigstens ein Fluor-Silikon-Kautschuk verwendet, da diese Materialien gleichzeitig noch einen sehr günstigen Quellgrad, insbesondere in Medien wie Wasser, Diesel, Rapsmethylester und dergleichen, aufweisen. Ein auf diese Weise passivierter Piezoaktor 10 kann somit vorteilhaft in einem Dieselaggregat eingesetzt werden, wobei der Piezoaktor 10 problemlos von den zuvor genannten Medien umspült werden kann, ohne an Dichtigkeit zu verlieren.

## Patentansprüche

1. Piezoelektrisches Bauteil mit einer auf dem Bauteil aufgebrachten Passivierung (20), **dadurch gekennzeichnet, daß** die Passivierung ein Passivierungsmaterial aufweist, dessen Reißfestigkeit kleiner ist als die Haftfestigkeit des Passivierungsmaterials auf dem piezoelektrischen Bauteil.

2. Piezoelektrisches Bauteil nach Anspruch 1, **dadurch gekennzeichnet, daß** die Passivierung (20) als Passivierungsschicht ausgeführt ist.

3. Piezoelektrisches Bauteil nach einem der Ansprüche 1 oder 2, **dadurch gekennzeichnet, daß** das Passivierungsmaterial aus wenigstens einem Kunststoff gebildet ist.

4. Piezoelektrisches Bauteil nach einem der Ansprüche 1 bis 3, **dadurch gekennzeichnet, daß** das Passivierungsmaterial aus wenigstens einem Material gebildet ist, das während der Verarbeitung niederviskose Eigenschaften aufweist.

5. Piezoelektrisches Bauteil nach einem der vorhergehenden Ansprüche, **dadurch gekennzeichnet, daß** das Passivierungsmaterial aus wenigstens einem Polyurethan gebildet ist.

6. Piezoelektrisches Bauteil nach einem der vorhergehenden Ansprüche, **dadurch gekennzeichnet, daß** das Passivierungsmaterial aus wenigstens einem Material auf Fluor-Basis gebildet ist.

7. Piezoelektrisches Bauteil nach Anspruch 6, **dadurch gekennzeichnet, daß** das Passivierungsmaterial aus Fluor-Kunststoff gebildet ist.

8. Piezoelektrisches Bauteil nach einem der vorhergehenden Ansprüche, **dadurch gekennzeichnet, daß** das Passivierungsmaterial aus wenigstens einem Harz gebildet ist.

9. Piezoelektrisches Bauteil nach einem der vorhergehenden Ansprüche, **dadurch gekennzeichnet, daß** das Passivierungsmaterial aus wenigstens einem Material aus der Gruppe der Latices gebildet ist.

10. Piezoelektrisches Bauteil nach einem der vorhergehenden Ansprüche, **dadurch gekennzeichnet, daß** das Passivierungsmaterial aus wenigstens einem Material aus der Gruppe der Polyimide und/oder der Polyamide und/oder der Polymethylacrylate und/oder der Parylene gebildet ist.

11. Piezoelektrisches Bauteil nach einem der vorhergehenden Ansprüche, **dadurch gekennzeichnet, daß** die Passivierung (20) dieses einen Quellgrad in flüssigen Medien von ≤ 40 % aufweist.

12. Piezoelektrisches Bauteil nach einem der vorhergehenden Ansprüche, **dadurch gekennzeichnet, daß** die Passivierung (20) eine Dauertemperaturbeständigkeit von > 150 °C aufweist.

13. Piezoelektrisches Bauteil nach einem der vorhergehenden Ansprüche, **dadurch gekennzeichnet, daß** das Bauteil als piezoelektrischer Aktor oder als piezoelektrischer Wandler ausgebildet ist.

14. Piezoelektrisches Bauteil nach einem der vorhergehenden Ansprüche, **dadurch gekennzeichnet, daß** das Bauteil als piezoelektrischer Aktor in einem Dieselantriebsaggregat ausgebildet ist.

15. Piezoelektrisches Bauteil nach einem der vorhergehenden Ansprüche, **dadurch gekennzeichnet, daß** es als Vielschichtbauelement mit einem Stapel (18) aus einer Anzahl von jeweils alternierend angeordneten piezoelektrischen Keramikschichten (11) und Elektrodenschichten (12, 13) ausgebildet ist.

16. Piezoelektrisches Bauteil nach Anspruch 15, **dadurch gekennzeichnet, daß** sich die Elektrodenschichten (12, 13) zumindest bereichweise bis zu wenigstens zu einer seitlichen Oberfläche (19) des Stapels (18) erstrecken.

17. Piezoelektrisches Bauteil nach Anspruch 16, **dadurch gekennzeichnet, daß** die Passivierung (20) auf der seitlichen Oberfläche (19) des Stapels (18) aufgebracht ist.

18. Piezoelektrisches Bauteil nach einem der Ansprüche 15 bis 17, **dadurch gekennzeichnet, daß** alle Oberflächen (19) des Stapels (18) mit der Passivierung (20) versehen sind.

19. Piezoelektrisches Bauteil nach einem der Ansprüche 15 bis 18, **dadurch gekennzeichnet, daß** Elektrodenschichten (12, 13) gleicher Polarität mit einer Außenmetallisierung (15) verbunden sind.

20. Piezoelektrisches Bauteil nach einem der vorhergehenden Ansprüche, **dadurch gekennzeichnet, daß** es von der Passivierung (20) umhüllt ist.

21. Piezoelektrisches Bauteil nach einem der vorhergehenden Ansprüche, **dadurch gekennzeichnet, daß** die Haftfestigkeit der Passivierung (20) auf dem piezoelektrischen Bauteil mittels eines Haftvermittlers erreicht ist.

## Claims

1. Piezoelectric component comprising a passivation (20) applied on the component, **characterized in that** the passivation comprises a passivation material whose tear strength is lower than the adhesive strength of the passivation material on the piezoelectric component.

2. Piezoelectric component according to Claim 1, **characterized in that** the passivation (20) is embodied as a passivation layer.

3. Piezoelectric component according to either of Claims 1 and 2, **characterized in that** the passivation material is formed from at least one plastic.

4. Piezoelectric component according to any of Claims 1 to 3, **characterized in that** the passivation material is formed from at least one material which has low-viscosity properties during processing.

5. Piezoelectric component according to any of the preceding claims, **characterized in that** the passivation material is formed from at least one polyurethane.

6. Piezoelectric component according to any of the preceding claims, **characterized in that** the passivation material is formed from at least one fluorine-based material.

7. Piezoelectric component according to Claim 6, **characterized in that** the passivation material is formed from fluorine plastic.

8. Piezoelectric component according to any of the preceding claims, **characterized in that** the passivation material is formed from at least one resin.

9. Piezoelectric component according to any of the preceding claims, **characterized in that** the passivation material is formed from at least one material from the group of latices.

10. Piezoelectric component according to any of the preceding claims, **characterized in that** the passivation material is formed from at least one material from the group of polyimides and/or polyamides and/or polymethyl acrylates and/or parylenes.

11. Piezoelectric component according to any of the preceding claims, **characterized in that** the passivation (20) has a degree of swelling in liquid media of ≤ 40%.

12. Piezoelectric component according to any of the preceding claims, **characterized in that** the passivation (20) has a long-term temperature stability of > 150°C.

13. Piezoelectric component according to any of the preceding claims, **characterized in that** the component is embodied as a piezoelectric actuator or as a piezoelectric transducer.

14. Piezoelectric component according to any of the preceding claims, **characterized in that** the component is embodied as a piezoelectric actuator in a diesel drive unit.

15. Piezoelectric component according to any of the preceding claims, **characterized in that** it is embodied as a multilayer component comprising a stack (18) formed from a number of piezoelectric ceramic layers (11) and electrode layers (12, 13) respectively arranged alternately.

16. Piezoelectric component according to Claim 15, **characterized in that** the electrode layers (12, 13) extend at least in regions as far as at least a lateral surface (19) of the stack (18).

17. Piezoelectric component according to Claim 16, **characterized in that** the passivation (20) is applied on the lateral surface (19) of the stack (18).

18. Piezoelectric component according to any of Claims 15 to 17, **characterized in that** all the surfaces (19) of the stack (18) are provided with the passivation (20).

19. Piezoelectric component according to any of Claims 15 to 18, **characterized in that** electrode layers (12, 13) of identical polarity are connected to an outer metallization (15).

20. Piezoelectric component according to any of the preceding claims, **characterized in that** it is encapsulated by the passivation (20).

21. Piezoelectric component according to any of the preceding claims, **characterized in that** the adhesive strength of the passivation (20) on the piezoelectric component is achieved by means of an adhesion promoter.

## Revendications

1. Composant piézoélectrique ayant une passivation ( **20** déposée sur le composant, **caractérisé en ce que** la passivation comporte une matière de passivation dont la résistance à la traction est plus petite que la force d'adhérence de la matière de passivation sur le composant piézoélectrique.

2. Composant piézoélectrique suivant la revendication 1, **caractérisé en ce que** la passivation ( 20 ) est réalisée sous la forme d'une couche de passivation.

3. Composant piézoélectrique suivant l'une des revendications 1 ou 2, **caractérisé en ce que** la matière de passivation est formée d'au moins une matière plastique.

4. Composant piézoélectrique suivant l'une des revendications 1 à 3, **caractérisé en ce que** la matière de passivation est formée d'au moins une matière qui a des propriétés de viscosité basses pendant le traitement.

5. Composant piézoélectrique suivant l'une des revendications précédentes, **caractérisé en ce que** la matière de passivation est formée d'au moins un polyuréthane.

6. Composant piézoélectrique suivant l'une des revendications précédentes, **caractérisé en ce que** la matière de passivation est formée d'au moins une matière à base de fluor.

7. Composant piézoélectrique suivant la revendication 6, **caractérisé en ce que** la matière de passivation est formée d'une matière plastique fluorée.

8. Composant piézoélectrique suivant l'une des revendications précédentes, **caractérisé en ce que** la matière de passivation est formée d'au moins une résine.

9. Composant piézoélectrique suivant l'une des revendications précédentes, **caractérisé en ce que** la matière de passivation est formée d'au moins une matière du groupe des latex.

10. Composant piézoélectrique suivant l'une des revendications précédentes, **caractérisé en ce que** la matière de passivation est formée d'au moins une matière du groupe des polyimides et/ou des polyamides et/ou des polyméthacrylate et/ou des parylènes.

11. Composant piézoélectrique suivant l'une des revendications précédentes, **caractérisé en ce que** la passivation ( 20 ) de celui-ci a un degré de gonflement dans des milieux liquides moins de ou égal à 40 %.

12. Composant piézoélectrique suivant l'une des revendications précédentes, **caractérisé en ce que** la passivation ( 20 ) a une stabilité permanente par rapport à une température supérieure à 150°C.

13. Composant piézoélectrique suivant l'une des revendications précédentes, **caractérisé en ce que** le composant est constitué sous la forme d'un actionneur piézoélectrique ou d'un transducteur piézoélectrique.

14. Composant piézoélectrique suivant l'une des revendications précédentes, **caractérisé en ce que** le composant est constitué sous la forme d'un actionneur piézoélectrique dans un groupe de moteur diesel.

15. Composant piézoélectrique suivant l'une des revendications précédentes, **caractérisé en ce qu'**il est constitué sous la forme d'un composant stratifié ayant une pile ( 18 ) composée d'un certain nombre de couches ( 11 ) piézoélectriques en céramique et de couches ( 12, 13 ) d'électrodes disposées respectivement en alternance.

16. Composant piézoélectrique suivant la revendication 15, **caractérisé en ce que** les couches ( 12, 13 ) d'électrodes s'étendent au moins par parties jusqu'à au moins une surface ( 19 ) latérale de la pile ( 18 ).

17. Composant piézoélectrique suivant la revendication 16, **caractérisé en ce que** la passivation ( 20 est déposée sur la surface ( 19 ) latérale de la pile ( 18 ).

18. Composant piézoélectrique suivant l'une des revendications 15 à 17, **caractérisé en ce que** toutes les surfaces ( 19 ) de la pile ( 18 ) sont munies de la passivation ( 20 ).

19. Composant piézoélectrique suivant l'une des revendications 15 à 18, **caractérisé en ce que** des couches ( 12, 13 ) d'électrodes de même polarité sont reliées à une métallisation ( 15 ) extérieure.

20. Composant piézoélectrique suivant l'une des revendications précédentes, **caractérisé en ce qu'**il est enrobé de la passivation ( 20 ).

21. Composant piézoélectrique suivant l'une des revendications précédentes, **caractérisé en ce que** la force d'adhérence de la passivation ( 20 ) sur le composant piézoélectrique est obtenue au moyen d'un agent favorisant l'adhérence.
